(19) **Europäisches Patentamt / European Patent Office / Office européen des brevets**

(11) **EP 4 752 631 A2**

(12) # EUROPEAN PATENT APPLICATION

(43) Date of publication:
**03.06.2026 Bulletin 2026/23**

(21) Application number: **26162080.1**

(22) Date of filing: **03.03.2026**

(51) International Patent Classification (IPC):
**G03F 7/00** (2006.01)

(52) Cooperative Patent Classification (CPC):
**G03F 7/70925; G03F 7/7085**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(71) Applicant: **ASML Netherlands B.V.**
**5500 AH Veldhoven (NL)**

(72) Inventors:
• **SCHULTE, Malte, Georg, Hendrik**
**5500AH Veldhoven (NL)**
• **SCHOLTEN, Bert, Dirk**
**5500AH Veldhoven (NL)**
• **MOHAMMED, Mahir, Asif**
**5500AH Veldhoven (NL)**

(74) Representative: **ASML Netherlands B.V.**
**Corporate Intellectual Property**
**P.O. Box 324**
**5500 AH Veldhoven (NL)**

(54) **METHOD OF ALIGNING A CLEANING UNIT WITH AN OBJECT TO BE CLEANED AND APPARATUS FOR PERFORMING SAID METHOD**

(57) A method of calibrating a cleaning position of an object to be cleaned with respect to a cleaning unit, the cleaning unit being configured to emit electromagnetic radiation measurable by a sensor, the method comprising the following steps: a) moving the sensor and/or the cleaning unit for the sensor to receive the electromagnetic radiation; b) measuring the electromagnetic radiation using the sensor; c) determining an alignment-improved position of the sensor with respect to the cleaning unit based on the measured electromagnetic radiation; d) determining the cleaning position of the object to be cleaned in accordance with the alignment-improved position of the sensor.

**FIG. 2B**

**Description**

FIELD

The present invention relates to a method for calibrating a cleaning position of an object to be cleaned with respect to a cleaning unit, as well as a workpiece support, an exposure apparatus (e.g., a lithographic apparatus), a processing system and a computer program which are configured to perform the method.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

In exposure apparatus such as lithography apparatus, and specifically in EUV lithography apparatus, components and/or workpieces such as wafers (which may be photoresist-coated) are exposed to radiation, such as EUV radiation. These components and/or workpieces may release hydrocarbons, which may be decomposed into reactive hydrocarbon radicals under influence of the (EUV) radiation. These reactive hydrocarbon radicals may result in a carbon layer build-up on components, thus resulting in contamination of these components, for example components in the vicinity of EUV-exposed workpieces. These components may for example include the positioning module, wafer table, and/or mask table, and the various sensors mounted thereon for measuring position-related information of the workpieces. The workpieces may for example include wafers and reticles. Therefore, over time, due to the contamination, the functioning of the contaminated components may degrade.

The contaminated components may be cleaned by (partially) removing the carbon layer which has built up over time. Said cleaning may (partially) restore the functionality of the cleaned components. A cleaning unit of the exposure apparatus is configured to clean the component (also referred to as the object to be cleaned), such as for example a sensor of the exposure apparatus. For example, the cleaning unit is configured to generate a gas flow which, when the cleaning unit is positioned in the vicinity of the object to be cleaned, interacts with the object to be cleaned in order to remove the contamination, the contamination for example comprising carbon atoms. For example, the gas flow comprises hydrogen radicals which react with the carbon layer on the object to be cleaned. The reaction of the hydrogen radicals with the carbon atoms for example results in a gas (such as methane gas) which may be extracted from the (vicinity of the) object to be cleaned.

The cleaning unit is (or comprises) for example a Hydrogen Radical Generator (HRG) unit. The hydrogen radicals are for example generated by the HRG from a hydrogen gas which is heated by the HRG. Said heating results in thermal cracking of $H_2$ into hydrogen radicals. To this end, the HRG unit comprises a heating element such as a (Tungsten) filament.

In other examples, the cleaning unit may be configured to generate a plasma or a laser beam which similarly interacts with the carbon layer on the object to be cleaned in order to (partially) remove said carbon layer, thereby cleaning the object to be cleaned.

The cleaning efficiency of the cleaning unit may for example be measured as the total amount of carbon atoms being removed by the cleaning unit in a specific period of time, and/or the total amount of time required to sufficiently remove the contamination from the object to be cleaned. The cleaning efficiency of the cleaning unit may in some cases be sub-optimal. For example, the total amount of carbon atoms being removed by the cleaning unit in a specific period of time may be lower than expected, and/or the total amount of carbon atoms being removed by the cleaning unit in a specific period of time may be longer than expected.

It is desirable to improve the cleaning efficiency of the cleaning unit, which may contribute to the overall efficiency of the exposure apparatus, e.g., measured as the throughput of the apparatus. For example, the control algorithm with which the cleaning unit is controlled may have an impact on the cleaning efficiency of the cleaning unit. It is an object of the invention to provide for such control algorithms.

SUMMARY

It has been found that the cleaning efficiency of the cleaning unit may be influenced in part by the alignment of the cleaning unit with respect to the object to be cleaned. An improved alignment between the cleaning unit and the object to be cleaned may contribute to improving the cleaning efficiency of the cleaning unit.

The object of the invention is achieved, according to a first aspect of the invention, by a method of calibrating a cleaning position of an object to be cleaned with respect to a cleaning unit, the cleaning unit being configured to emit electromagnetic radiation measurable by a sensor, the method comprising the following steps: a) moving the sensor and/or the cleaning unit for the sensor to receive the electromagnetic radiation; b) measuring the electromagnetic radiation using the sensor; c) determining an alignment-improved position of the sensor with respect to the cleaning unit based on the measured electromagnetic radiation; and d) determining the cleaning position of the object to be cleaned in accordance with the alignment-improved position of the sensor.

In an embodiment, the object to be cleaned and the sensor are mounted on a workpiece support, such as an object table or a mask table, and wherein the cleaning unit is configured to emit electromagnetic radiation in a direction transverse to the base.

In an embodiment, the sensor is an image sensor comprising an array of sensor elements, the cleaning unit comprising a source for generating a light beam. In step b), the method measures the light beam using the array of sensor elements, resulting in a plurality of light beam measurements, and in step c), the method determines the alignment-improved position of the image sensor with respect to the cleaning unit based on the plurality of light beam measurements.

In a variant of this embodiment, the image sensor further comprises an aperture pattern through which the light beam passes before being received by the image sensor, and wherein each of the plurality of light beam measurements corresponds to a respective aperture of the aperture pattern.

For example, in this embodiment and its variant, the source is a filament or a plasma or laser source.

For example, in this embodiment and its variant(s), the cleaning unit comprises a plurality of sources each for generating a distinct light beam, the sources being arranged in a pattern, wherein, in step a), the image sensor and/or the cleaning unit are moved for the image sensor to receive the light beams generated by the plurality of sources.

In an embodiment, in the step of determining the alignment-improved position of the sensor with respect to the cleaning unit, the method comprises the following sub-steps: determining a relative position of the cleaning unit with respect to the sensor based on the measured electromagnetic radiation; determining an offset between the determined relative position of the cleaning unit with respect to the sensor and an expected relative position of the cleaning unit with respect to the sensor; and determining the alignment-improved position of the sensor with respect to the cleaning unit in accordance with the determined offset.

In an embodiment, steps a) and b) are repeated multiple times. In each repetition of step a), the sensor and/or the cleaning unit are moved such that the sensor is positioned at a respective distinct position with respect to the cleaning unit. In each repetition of step b), an intensity of the electromagnetic radiation is determined. In step c), the alignment-improved position of the sensor with respect to the cleaning unit is determined to be the relative position of the sensor with respect to the cleaning unit corresponding to an optimal intensity of the electromagnetic radiation as determined in step b).

In a variant of this embodiment, the repetitions of step a) are performed according to a scan pattern.

In an embodiment, in step d), the cleaning position of the object to be cleaned is additionally determined in accordance with a predetermined fixed relative position of the object to be cleaned with respect to the sensor.

In an embodiment, the method further comprises the step of energizing the cleaning unit such that the electromagnetic radiation is generated.

In an embodiment, the cleaning unit comprises a hydrogen radical generator comprising an outlet for emitting a flow of hydrogen radical containing gas, and, in step a), the sensor and/or the cleaning unit are moved for the sensor to receive the flow.

In an embodiment, in step a), the sensor and/or the cleaning unit are moved in accordance with a predetermined expected relative position of the sensor with respect to the cleaning unit.

In an embodiment, the object to be cleaned is the sensor.

In an embodiment, in step b), the exposure time of the sensor is determined in accordance with an intensity of the electromagnetic radiation.

The object of the invention is achieved, according to a second aspect of the invention, by a method of cleaning an object to be cleaned with a cleaning unit. The method comprises the steps of: calibrating the cleaning position of the object to be cleaned with respect to the cleaning unit by performing the method according to the first aspect of the invention, moving the object to be cleaned and/or the cleaning unit such that the object to be cleaned is in the cleaning position with respect to the cleaning unit, and cleaning the object to be cleaned using the cleaning unit.

The object of the invention is achieved, according to a third aspect of the invention, by a computer program comprising program instructions configured to cause a processing system to perform the method according to the first aspect of the invention and/or the second aspect of the invention when the program is executed by the processing system.

The object of the invention is achieved, according to a fourth aspect of the invention, by a processing system comprising a processor and a storage device, the storage device comprising the computer program according to the third aspect of the invention.

The object of the invention is achieved, according to a fifth aspect of the invention, by a metrology, inspection and/or sensor apparatus comprising the processing system according to the fourth aspect of the invention.

In an embodiment, the metrology, inspection and/or sensor apparatus further comprises a transmission image sensor, a wavefront sensor, a level sensor, an alignment sensor and/or a sensor for aligning a first object support to a second object support.

The object of the invention is achieved, according to a sixth aspect of the invention, by an exposure apparatus comprising the processing system according to the fourth aspect of the invention.

The object of the invention is achieved, according to a seventh aspect of the invention, an exposure apparatus comprising the metrology, inspection and/or sensor apparatus according to the fifth aspect of the invention.

The object of the invention is achieved, according to an eighth aspect of the invention, a workpiece support, such as an object table or a mask table, for an exposure apparatus comprising a cleaning unit configured to generate electromagnetic radiation, the workpiece support having mounted thereon an object to be cleaned and a sensor, wherein the workpiece support is configured to: a) move the sensor for the sensor to receive the electromagnetic radiation; b) measure the electromagnetic radiation using the sensor; c) determine an alignment-improved position of the sensor with respect to the cleaning unit based on the measured electromagnetic radiation; and d) determine the cleaning position of the object to be cleaned in accordance with the alignment-improved position of the sensor.

The object of the invention is achieved, according to a ninth aspect of the invention, by an exposure apparatus, comprising: a workpiece support, such as the workpiece support according to the eighth aspect of the invention, with mounted thereon an object to be cleaned and a sensor and a cleaning unit configured to clean the object to be cleaned, the cleaning unit being configured to generate electromagnetic radiation. The exposure apparatus is configured to: a) move the image sensor and/or the cleaning unit for the sensor to receive the electromagnetic radiation; b) measure the electromagnetic radiation using the sensor; c) determine an alignment-improved position of the sensor with respect to the cleaning unit based on the measured electromagnetic radiation; and d) determine the cleaning position of the object to be cleaned in accordance with the alignment-improved position of the sensor.

BRIEF DESCRIPTION OF THE DRAWINGS

Embodiments of the invention will now be described, by way of example only, with reference to the accompanying schematic drawings, in which:

- Figure 1 depicts a lithographic system comprising a lithographic apparatus and a radiation source;

- Figures 2A and 2B depict a workpiece support such as an object table according to an embodiment of the invention.

- Figure 3 is a flow chart depicting the steps of the method according to an embodiment of the invention.

- Figures 4A and 4B depict a workpiece support such as an object table according to an embodiment of the invention.

- Figures 5A and 5B depict a cleaning unit according to an embodiment of the invention.

- Figures 6A and 6B depict a measurement, using an image sensor, of a cleaning unit according to an embodiment of the invention.

DETAILED DESCRIPTION

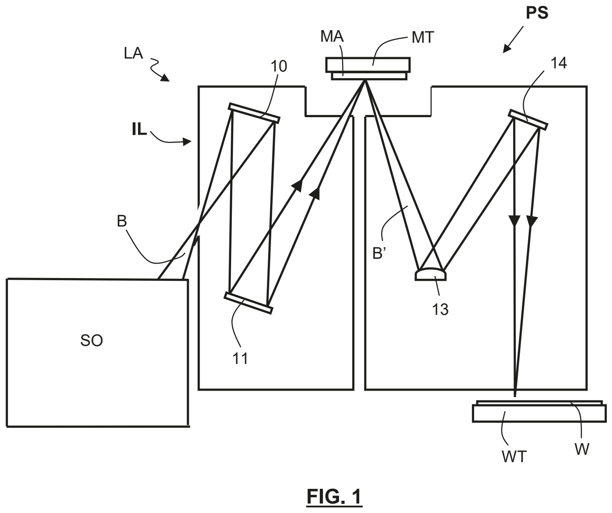

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13, 14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

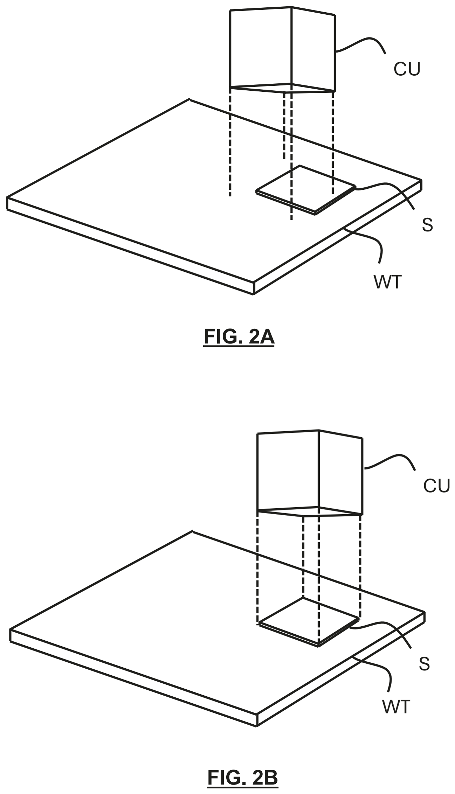

Figures 2A and 2B depict a workpiece support such as an object table according to an embodiment of the invention.

The figures depict an object table WT with mounted thereon a sensor S. The sensor S may be referred to as the object to be cleaned. The figures further depict a cleaning unit CU. In order to clean the sensor S, the cleaning unit CU and/or the sensor S is/are moved such that the sensor S is in a cleaning position with respect to the cleaning unit CU (or vice versa). The cleaning unit may for example be configured to remove a carbon layer build-up on the sensor S when the sensor S is in the cleaning position with respect to the cleaning unit CU. The cleaning unit CU is configured to generate a gas flow, or, alternatively, a laser beam or a plasma to clean the sensor S. The cleaning unit CU may be configured to clean the sensor surface. The sensor may comprise an aperture pattern, or a pattern of gratings, e.g., on the sensor surface. The aperture pattern may be configured to filter the (EUV) electromagnetic radiation impinging on the sensor before it impinges on the sensor elements which measure the electromagnetic radiation. Thus, the cleaning unit CU may be configured to clean the pattern of gratings of the sensor.

The components shown in Figures 2A and 2B may be part of an exposure apparatus, such as a lithography apparatus, which exposes work products within the machine to electromagnetic radiation, e.g., EUV radiation. Thus, the cleaning unit CU is configured to clean a sensor S in an EUV lithography apparatus.

Fig. 2A depicts a cleaning position in which the cleaning unit CU is not fully aligned with the sensor S. In the cleaning position shown in Fig. 2A, the gas flow/laser beam/plasma is not centered on the sensor S, which may negatively impact the cleaning efficiency. Fig. 2B depicts a cleaning position in which the cleaning unit CU may be said to be fully aligned with sensor S. In such a position, the gas flow/laser beam/plasma may be said to be centered on the sensor S, which may positively impact the cleaning efficiency.

The cleaning position may for example be determined in accordance with a predetermined expected relative position of the object to be cleaned (in this case, sensor S) with respect to the cleaning unit CU. Said predetermined expected relative position may for example be based on an expected mounting position of the cleaning unit CU and/or the object to be cleaned. In case said predetermined expected relative position differs from the actual relative position of cleaning unit CU with respect to the object to be cleaned, the cleaning unit CU may not be (completely) aligned with the object to be cleaned, as depicted in Fig. 2A, which may negatively impact cleaning efficiency.

The cleaning unit CU is configured to emit electromagnetic radiation. The cleaning unit CU may for example be considered to emit black-body radiation. The peak wavelength of the black-body radiation may be centered in the visible spectrum, or the peak wavelength may also be higher, e.g., at around 1 or 1.5 or 2 microns. The electromagnetic radiation emitted by the cleaning unit is measurable by a sensor. For example, the electromagnetic radiation is measurable by sensor S. In other words, sensor S is configured to measure the electromagnetic radiation emitted by the cleaning unit CU. However, sensor S (the object to be cleaned) may be optimized to measure EUV radiation, which is in a different spectral range than the black-body radiation emitted by the cleaning unit CU. The sensitivity of the sensor S may therefore only partially overlap with the black body radiation emitted by the cleaning unit CU. For example, the overlap may be 1% or 5% or 10%, which may require a longer exposure time to accurately measure the black-body radiation emitted by the cleaning unit CU. Using the sensor S to measure the electromagnetic radiation emitted by the cleaning unit CU may contribute to reducing cost and complexity, as an existing component of the EUV lithography apparatus is repurposed.

Alternatively, the electromagnetic radiation is measurable by a sensor different from sensor S. Thus, in other words, the sensor for measuring the electromagnetic radiation (which is different from sensor S) is configured to measure the electromagnetic radiation emitted by the cleaning unit CU. The sensitivity of the dedicated sensor may be optimized for measuring the black-body radiation emitted by the cleaning unit C. Using a dedicated sensor for measuring the electromagnetic radiation may contribute to increasing accuracy and/or speed of measuring said electromagnetic radiation. The sensor for measuring the electromagnetic radiation may be at a fixed relative position with respect to the object to be cleaned (i.e., with respect to the sensor S). The fixed relative position may be predetermined (e.g., known at construction time) or may be determined by measuring, with a position sensor, the position of the sensor for measuring the electromagnetic radiation and the position of sensor S (e.g., the object to be cleaned).

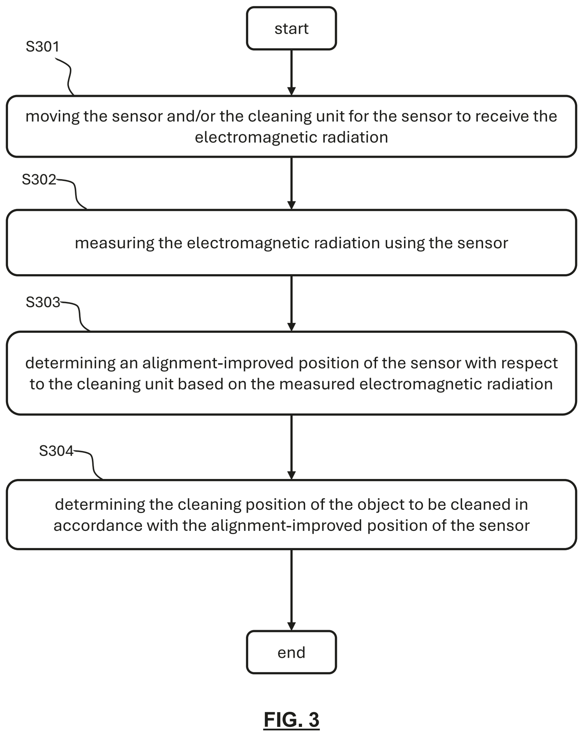

The electromagnetic radiation emitted by the cleaning unit CU may be measured in order to determine (e.g., calculate) an improved cleaning position of the object to be cleaned with respect to the cleaning unit CU, as detailed below with reference to Fig. 3.

Figure 3 is a flow chart depicting the steps of the method according to an embodiment of the invention.

The method according to the invention is a method of calibrating a cleaning position of an object to be cleaned with respect to a cleaning unit. The object to be cleaned may be located on a workpiece support such as an object table WT of an exposure apparatus such as a lithographic apparatus. The cleaning unit is configured to emit electromagnetic radiation, e.g., as a byproduct of a cleaning process in which the object to be cleaned is cleaned by the cleaning unit. For example, the cleaning unit may comprise a source for generating the electromagnetic radiation. The source of electromagnetic radiation may be a (Tungsten) filament, a plasma, a plasma source, or a laser source. The electromagnetic radiation emitted may for example be a light beam, which may be in the visible or invisible spectrum (such as UV or infrared light). The method uses a sensor, which may be located on the same workpiece support such as object table WT. The sensor is configured to measure the electromagnetic radiation (such as the light beam) emitted by the cleaning unit.

In a first step S301, the sensor and/or the cleaning unit are moved for the sensor to receive the electromagnetic radiation emitted by the cleaning unit. In this step, the sensor may be moved relative to the cleaning unit (for example, by moving the object table WT on which the sensor is mounted) and/or the cleaning unit may be moved relative to the sensor (for example, in case the cleaning unit is moveably mounted, e.g., within the exposure apparatus). In this step, the sensor and/or the cleaning unit are moved in accordance with a predetermined expected relative position of the sensor with respect to the cleaning unit such that the sensor is positioned to receive the electromagnetic radiation. The position in which the sensor is placed with respect to the cleaning unit may also be referred to as an initial estimate of a cleaning position of the sensor.

In certain embodiments, the cleaning unit is energized once the sensor is in a position with respect to the cleaning unit in which the sensor is to receive the electromagnetic radiation generated by the cleaning unit. Thus, after step S301, the sensor receives the electromagnetic radiation generated by the cleaning unit and is configured to measure said electromagnetic radiation.

In a second step S302, the sensor measures the electromagnetic radiation emitted by the cleaning unit. For example, the electromagnetic radiation may be a light beam or a laser beam or a plasma which is measurable by an image sensor. The measurement performed by the sensor may represent the intensity of the electromagnetic radiation, or other properties of the electromagnetic radiation such as relating to its spectral components. The exposure time with which the sensor measures the electromagnetic radiation may be determined in accordance with an intensity of the electromagnetic radiation. For example, the (maximum) intensity electromagnetic radiation emitted by the cleaning unit may be predicted or may be equal to a predetermined (known) value. The exposure time of the sensor may be set such that the sensor is saturated. The exposure time may for example depend on properties of the radiation emitted by the cleaning unit, e.g., the spectral range of the radiation emitted by the cleaning unit. For example, the cleaning unit may generate black body radiation of a source in a range of 1750 - 2500C with a peak wavelength in a range of 1 - 3 micron. The radiation emitted by the cleaning unit may be in the range of 0.5 - 3W. The exposure time may, additionally or alternatively, for example depend on properties of the sensor for measuring the electromagnetic radiation emitted by the cleaning unit, e.g., filtering properties of the sensor, sensor sensitivity, etc. For example, the intensity of the electromagnetic radiation reaching the sensor may be influenced by a filter which may filter the incoming radiation at a factor in the range of 1/10 - 1/2000. The sensitivity of the sensor may only partially overlap with the radiation emitted by the cleaning unit CU, for example wherein the overlap is within a range of 1/25 - 1/2. The exposure time is for example in the range of 5ms - 10s. The exposure time is for example controlled by instructing the sensor to measure the incoming electromagnetic radiation for the duration of the exposure time, e.g., the exposure time is controlled electronically. In other examples, the exposure time is controlled using a physical shutter (e.g., of the sensor) which is opened for the duration of the exposure time.

In a third step S303, the measurement performed in step S302 is used to determine an alignment-improved position of the sensor with respect to the cleaning unit. It is observed that the electromagnetic radiation emitted by the cleaning unit may be used as a measure of the alignment between the cleaning unit and the sensor which measures the electromagnetic radiation.

For example, in case the electromagnetic radiation emitted by the cleaning unit is a light beam, said light beam is measurable by a sensor which may comprise an array of sensor elements. The array of sensor elements measures the light beam at several locations, therewith obtaining a plurality of light beam measurements which provide a measure of the spatial variation in brightness over the sensor surface on which the sensor elements are arranged. From the plurality of light beam measurements, an offset may be determined between an expected alignment of the cleaning unit with respect to the sensor (or vice versa) and a measured alignment of the cleaning unit with respect to the sensor (or vice versa). Said measured/expected alignments may be based on an alignment between the center of the cleaning unit with respect to the center of the sensor (or vice versa). For example, in an ideally aligned location, it is to be expected that the center of the sensor receives the highest intensity of the electromagnetic radiation, which may correspond to the aligned position of the cleaning unit with respect to the sensor (or vice versa). Thus, the alignment-improved position of the sensor corresponds to a position of the sensor approaching the ideally aligned location. For example, an offset is added to the measurement position based on the measured light beam. The offset for example represents a new location of the sensor with respect to the cleaning unit in which measured light beam is centered with the sensor.

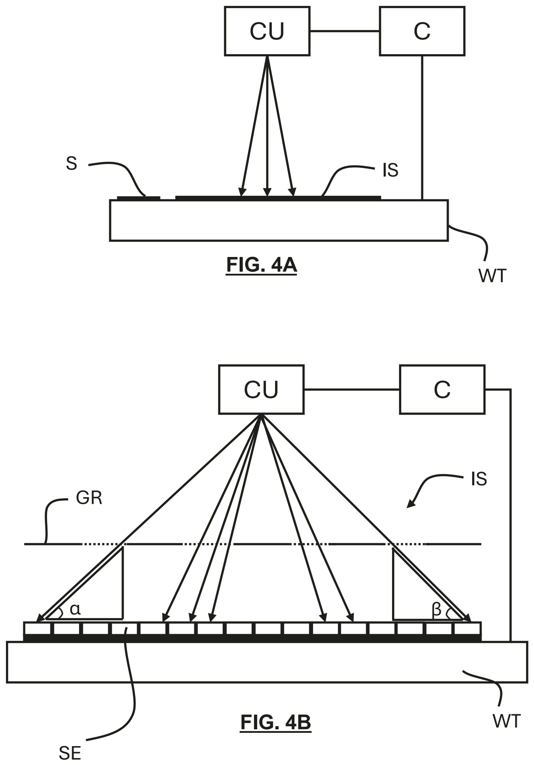

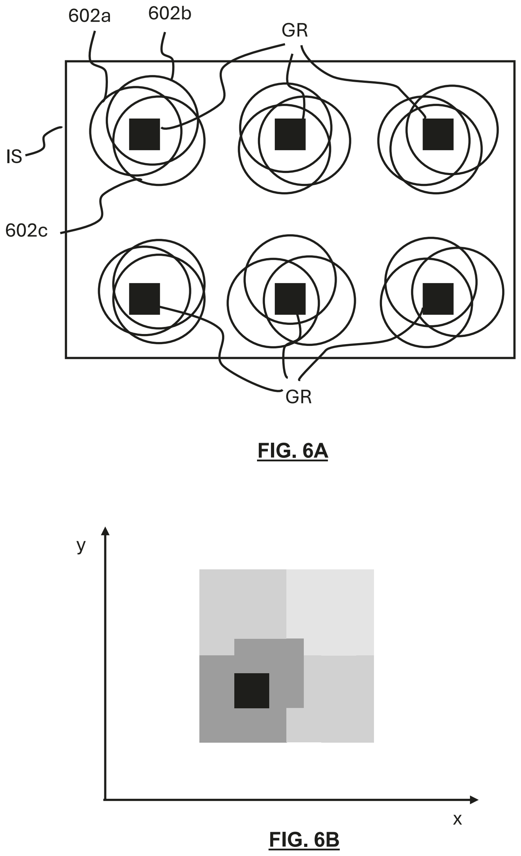

Another example of measurements performed by an image sensor with multiple sensor elements and a pattern of gratings is explained below with reference to Fig. 4B, as well as Fig. 6A.

Another example of multiple measurements performed by a sensor, in which the electromagnetic radiation emitted by the cleaning unit is performed at multiple locations according to a scan pattern, is explained below with reference to Fig. 6B.

In a fourth step S304, the cleaning position of the object to be cleaned is determined in accordance with the alignment-improved position of the sensor. For example, the object to be cleaned is also a sensor. The object to be cleaned may be the same sensor with which the electromagnetic radiation is measured. The object to be cleaned may also be a different sensor than the sensor with which the electromagnetic radiation is measured. In this case, the object to be cleaned has a predetermined fixed relative position with respect to the sensor with which the electromagnetic radiation is measured. Thereby, the alignment-improved position of the sensor is used to derive the (optimized) cleaning position of the object to be cleaned.

By measuring the electromagnetic radiation emitted by the cleaning unit, a cleaning position of the object to be cleaned with respect to the cleaning unit is determined. This optimized cleaning position may contribute to an increase in efficiency of the cleaning unit cleaning the object to be cleaned. For example, the optimized cleaning position may result in lower cleaning times and/or an increase in contamination which is removed by the cleaning unit from the object to be cleaned.

Figures 4A and 4B depict a workpiece support such as an object table WT according to an embodiment of the invention.

An image sensor IS is mounted on object table WT. The image sensor IS is configured to measure the electromagnetic radiation emitted by the cleaning unit CU. The cleaning unit CU is configured to emit electromagnetic radiation (such as a light beam or laser beam) in a direction transverse to the object table WT, as illustrated in Figures 2A and 2B. A controller C is in communication with the cleaning unit CU and the object table WT and is configured to perform the method according to the invention.

In a first step of the method, the image sensor IS and/or the cleaning unit CU is/are moved for the image sensor to receive the electromagnetic radiation emitted by cleaning unit CU. For example, the image sensor IS and/or the cleaning unit CU is/are moved such that the image sensor IS is in an initial cleaning position with respect to the cleaning unit CU. Said initial cleaning position may for example be determined in accordance with a predetermined expected relative position of the image sensor IS with respect to the cleaning unit CU.

In a next step of the method, the image sensor IS measures the electromagnetic radiation emitted by the cleaning unit CU. For example, the cleaning unit CU comprises a source for generating a light beam and the image sensor measures the light beam, which results in a light beam measurement. The source may for example be a (Tungsten) filament which produces heat and light within the visible spectrum. Alternatively, the source may be a plasma or a laser source which also produce light within the visible spectrum. Alternatively, the source may produce light within the invisible spectrum, such as UV or infrared light.

In a next step of the method, an alignment-improved position of the image sensor IS with respect to the cleaning unit CU is determined based on the electromagnetic radiation measurement, for example based on the light beam measurement. For example, in this step, a relative position of cleaning unit CU with respect to image sensor IS may be determined based on the measured electromagnetic radiation. The relative position may be a position of the image sensor IS with respect to cleaning unit CU in a plane parallel to the surface of object table WT. The relative position may for example be a position of the center of the image sensor IS with respect to the center of cleaning unit CU. The determined relative position of the cleaning unit CU is subsequently compared to an expected relative position of the image sensor IS with respect to cleaning unit CU to determine an offset. For example, said expected relative position is a predetermined value. The predetermined value for example corresponds to a position in which the center of the image sensor IS is aligned with the center of cleaning unit CU. The alignment-improved position of the image sensor IS with respect to the cleaning unit CU is subsequently determined in accordance with the determined offset. For example, the determined offset is added to the (initial) cleaning position of the image sensor IS with respect to the cleaning unit CU, therewith obtaining an alignment-improved position of the image sensor IS with respect to the cleaning unit CU.

In a next step of the method, the cleaning position of the object to be cleaned (such as sensor S) with respect to the cleaning unit CU is determined. The cleaning position may be determined in accordance with a predetermined fixed relative position of the object to be cleaned (such as sensor S) with respect to the sensor for measuring the electromagnetic radiation (such as sensor IS). For example, the predetermined fixed relative position is a position within a plane parallel to the surface of the object table WT whereupon the sensor S and/or the sensor IS is/are mounted. In other words, the alignment-improved position is determined for the sensor which measures the electromagnetic radiation emitted by the cleaning unit CU (in the example of Fig. 4A, the sensor which measures the electromagnetic radiation emitted by the cleaning unit CU is image sensor IS), while the cleaning position is determined for the object to be cleaned (in the example of Fig. 4A, the object to be cleaned is sensor S). In certain examples, the object to be cleaned is the sensor which measures the electromagnetic radiation, in which case the alignment-improved position and the cleaning position are identical. In other examples, the object to be cleaned is different from the sensor which measures the electromagnetic radiation, in which case the alignment-improved position and the cleaning position are different. In such a case, the relative position of the object to be cleaned with respect to the sensor which measures the electromagnetic radiation is known, i.e., is a predetermined value (for example, the relative position of sensor S with respect to image sensor IS in the example of Fig. 4A is known). Therewith, the cleaning position of the object to be cleaned may be determined based on the alignment-improved position of the sensor.

The image sensor IS may comprise multiple sensor elements SE, forming, e.g., an n x m array of sensor elements SE, as shown in Fig. 4B. For example, the array of sensor elements corresponds to a CCD array of photosensitive pixels (photosites). The light beam emitted by cleaning unit CU is measured using the array of sensor elements, resulting in a plurality of light beam measurements. The image sensor IS further comprises an aperture pattern, or a pattern of gratings, GR, through which the light beam generated by the cleaning unit CU passes before being received by the image sensor IS (i.e., by the sensor elements SE). Each of the plurality of light beam measurements is performed by one or more respective sensor elements SE and corresponds to a respective aperture (or grating) of the aperture pattern (or grating pattern). Thus, each light beam measurement may be said to correspond to a projection of the light beam generated by the cleaning unit CU through a respective grating.

In practice, the sensor elements SE form an n x m matrix of photosensitive pixels which are configured to capture an n x m image of the radiation received through the grating GR. The grating pattern GR of the image sensor IS typically comprises array of longitudinal apertures. Based on this predetermined (i.e., known) geometry of grating pattern GR and the plurality of light beam measurements, the alignment of the grating pattern GR with respect to the cleaning unit CU is determined. To determine said alignment, the position of the grating (in dimensions x,y,z) relative to the electromagnetic radiation source (e.g., filament) of the cleaning unit is determined. The position of the grating relative to said radiation source may be determined as follows:

$$(1) \quad \alpha = \arctan\left(h_c/d_n\right)$$

$$(2) \quad \beta = \arctan(h_c/d_m)$$

$$(3) \quad h = (L * \sin(\alpha) * \sin(\beta)) / \sin(\alpha + \beta)$$

$$(4) \quad A = h/\tan(\alpha)$$

$$(5) \quad B = h/\tan(\beta)$$

In the above formula, $h_c$ is the (known, i.e., predetermined) height of the grating pattern with respect to the sensor elements SE, $d_n$ is the length of the base of the right triangle with angle $\alpha$, $d_m$ is the length of the base of the right triangle with angle $\beta$, h is the calculated height of the cleaning unit CU with respect to the sensor elements SE, L is the (known, i.e., predetermined) width of the matrix of photosensitive pixels, i.e., the length between the first sensor element SE shown to the left of Fig. 4B and the last sensor element SE shown to the right of Fig. 4B. The quantities A and B are used to determine the (mis)alignment between the cleaning unit CU and the grating pattern GR.

The integration time of the sensor elements SE measuring the light beam(s) may be influenced by the gratings GR. The gratings may filter the incoming light and thus partly block the light beam. Further, the size of the gratings GR may be in the range of 0.1-50 $\mu m^2$, which reduces the intensity of the light which is generated by the cleaning unit CU passing through the gratings GR.

The pattern of gratings GR is arranged at a predefined height with respect to sensor elements SE. An offset of each of the light beam measurements to an ideal aligned position of the cleaning unit CU with respect to the image sensor IS is determined. This offset is determined based on the plurality of light beam measurements. An expected position of each of the plurality of light beams on the sensing surface (comprising the sensor elements SE) is compared to the measured plurality of light beams. The expected position may be a position in which the center of the cleaning unit is aligned with a sensor element SE of image sensor IS. The offset thus determined corresponds to an offset of the cleaning unit with respect to the image sensor IS in a plane parallel to the surface of the object table WT.

The alignment-improved position of the image sensor IS with respect to the cleaning unit is determined based on the plurality of light beam measurements. From the determined offset, an alignment-improved position may be determined in which the offset is minimized, i.e., in which the measurements of the plurality of light beams are closer aligned to the expected position of said plurality of light beams. In other words, when the image sensor is placed in the alignment-improved position, the offset between the position of the measured plurality of light beams and the expected position of said plurality of light beams is minimized.

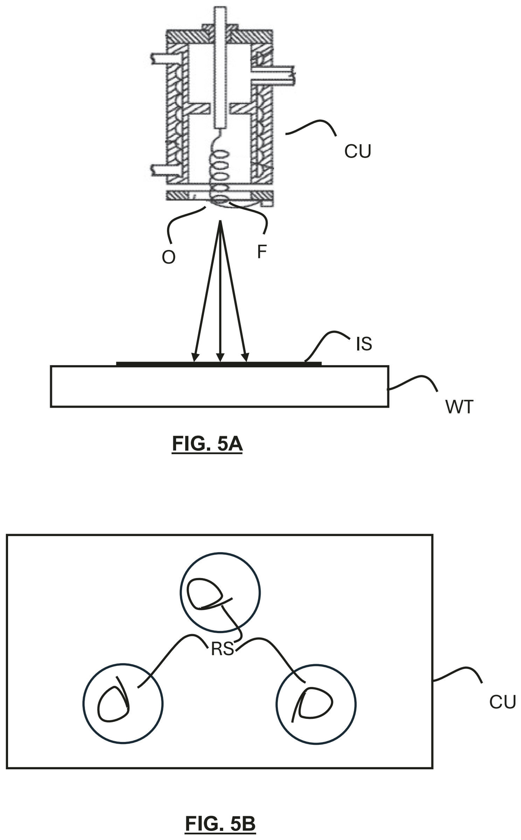

Figures 5A and 5B depict a cleaning unit according to an embodiment of the invention.

Figure 5A is an example of a cleaning unit CU, wherein the cleaning unit CU comprises a hydrogen radical generator comprising an outlet O for emitting a flow of hydrogen radical containing gas. In step S301 of the method according to the invention, the sensor and/or the cleaning unit may be moved for the sensor to receive the flow. The cleaning unit comprises a (Tungsten) filament F which is configured to heat a hydrogen gas, thereby cracking the hydrogen gas into hydrogen radicals. The image sensor IS is configured to measure the light beam generated by the filament F when it is heated (i.e., when it is turned on). The cleaning rate of the cleaning unit CU may be highest directly below the filament, as the filament may represent the center of the gas flow which is emitted by the cleaning unit CU.

As is shown in Fig. 5B, the cleaning unit may comprise a plurality of sources RS, the sources RS each being for example a (Tungsten) filament. Each source RS is arranged for generating a distinct light beam, the sources being arranged in a pattern, wherein, in step S301 of the method, the image sensor and/or the cleaning unit are moved for the image sensor to receive the light beams generated by the plurality of sources. In step S302 of the method, the electromagnetic radiation emitted by all of the sources RS is measured. This measurement is further explained with reference to Figure 6A, below.

Figures 6A and 6B depict a measurement, using an image sensor, of a cleaning unit according to an embodiment of the invention.

Depicted in Figure 6A is a measurement surface of an image sensor which comprises a plurality of apertures, or gratings, GR. The gratings are positioned in between the sources of electromagnetic radiation, e.g., the filaments shown in Fig. 5A. Depicted in Fig. 6A are bright spots 602a-602c which are the result of each of the filaments generating a separate light beam. Therefore, each grating GR is associated with three of these bright spots, being the projection of the light beams generated by the filaments passing through the gratings GR. In total, with 6 gratings and three filaments, 18 of these spots are measurable by the image sensor IS. Each spot can be traced back to its corresponding grating GR, and thereby also to the source RS which generated the measured light beam which generated the spot. Using the height at which the gratings are arranged with respect to the image sensor surface, as well as the position of the gratings, the misalignment of the image sensor with respect to the filament when compared to an optimized cleaning position (or an alignment-optimized position) is determined.

By performing a single image capture in which multiple measurements of the light beam are performed across the image sensor surface, the optimized cleaning position of the object to be cleaned may be determined from a single exposure of the image sensor. This may further contribute to the efficiency of the approach.

Alternatively, instead of a single image capture, the steps S301 and S302 of the method are repeated multiple times, as depicted in Fig. 6B. In each repetition of step S301, the sensor and/or the cleaning unit are moved such that the sensor for measuring the electromagnetic radiation emitted by the cleaning unit CU is positioned at a respective distinct position with respect to the cleaning unit CU. For example, these repetitions of step S301 are performed according to a scan pattern. The scan pattern may be performed in a plane parallel to the surface of the workpiece support, such as in a plane parallel to the object table WT. The scan pattern may define an xy-grid (as shown in Fig. 6B), wherein each position in the grid corresponds to a location in which a measurement of the electromagnetic radiation emitted by the cleaning unit CU is performed.

In each repetition of step S302, an intensity of the electromagnetic radiation emitted by the cleaning unit CU is determined. For example, the brightness of a light beam generated by a filament of a hydrogen radical generating unit is determined in each repetition of step S301 at a distinct location of the sensor with respect to the cleaning unit CU. In step S303, the alignment-improved position of the sensor with respect to the cleaning unit is determined to be the relative position of the sensor with respect to the cleaning unit corresponding to an optimal intensity of the electromagnetic radiation as determined in step S302.

As shown in Fig. 6B, once the scan pattern is complete, a brightness map may be constructed, in which darker locations correspond to locations in which the measured electromagnetic radiation emitted by the cleaning unit is higher.

By performing a scan pattern, the optimized cleaning position may be determined using relatively low-complexity hardware, as a grating pattern is not necessary in this embodiment. Rather, the electromagnetic radiation emitted by the cleaning unit may be directly measured. Thus, each measurement of the electromagnetic radiation across the scan pattern may be performed in a short amount of time. The determination of the optimized cleaning location may be performed using relatively low-complexity calculation, as said optimized cleaning location corresponds to the brightest spot in the determined brightness map.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography. Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Further, this document describes the following clauses of the present invention:

1. A method of calibrating a cleaning position of an object to be cleaned with respect to a cleaning unit, the cleaning unit being configured to emit electromagnetic radiation measurable by a sensor, the method comprising the following steps:

a) moving the sensor and/or the cleaning unit for the sensor to receive the electromagnetic radiation;
b) measuring the electromagnetic radiation using the sensor;
c) determining an alignment-improved position of the sensor with respect to the cleaning unit based on the measured electromagnetic radiation;
d) determining the cleaning position of the object to be cleaned in accordance with the alignment-improved position of the sensor.

2. The method according to clause 1, wherein the object to be cleaned and the sensor are mounted on a workpiece support, such as an object table or a mask table, and wherein the cleaning unit is configured to emit electromagnetic radiation in a direction transverse to the base.

3. The method according to any one of the preceding clauses, wherein:

the sensor is an image sensor comprising an array of sensor elements;
the cleaning unit comprising a source for generating a light beam;
in step b), the method measures the light beam using the array of sensor elements, resulting in a plurality of light beam measurements; and
in step c), the method determines the alignment-improved position of the image sensor with respect to the cleaning unit based on the plurality of light beam measurements.

4. The method according to clause 3, wherein the image sensor further comprises an aperture pattern through which the light beam passes before being received by the image sensor, and wherein each of the plurality of light beam measurements corresponds to a respective aperture of the aperture pattern.

5. The method according to any one of clauses 3-4, wherein the source is a filament or a plasma or laser source.

6. The method according to any one of clauses 3-5, wherein the cleaning unit comprises a plurality of sources each for generating a distinct light beam, the sources being arranged in a pattern, wherein, in step a), the image sensor and/or the cleaning unit are moved for the image sensor to receive the light beams generated by the plurality of sources.

7. The method according to any one of the preceding clauses, wherein, in the step of determining the alignment-improved position of the sensor with respect to the cleaning unit, the method comprises the following sub-steps:

- determining a relative position of the cleaning unit with respect to the sensor based on the measured electromagnetic radiation;
- determining an offset between the determined relative position of the cleaning unit with respect to the sensor and an expected relative position of the cleaning unit with respect to the sensor;
- determining the alignment-improved position of the sensor with respect to the cleaning unit in accordance with the determined offset.

8. The method according to any one of clauses 1-6, wherein steps a) and b) are repeated multiple times, wherein:

- in each repetition of step a), the sensor and/or the cleaning unit are moved such that the sensor is positioned at a respective distinct position with respect to the cleaning unit;
- in each repetition of step b), an intensity of the electromagnetic radiation is determined;
- in step c), the alignment-improved position of the sensor with respect to the cleaning unit is determined to be the relative position of the sensor with respect to the cleaning unit corresponding to an optimal intensity of the electromagnetic radiation as determined in step b).

9. The method according to clause 8, wherein the repetitions of step a) are performed according to a scan pattern.

10. The method according to any one of the preceding clauses, wherein, in step d), the cleaning position of the object to be cleaned is additionally determined in accordance with a predetermined fixed relative position of the object to be cleaned with respect to the sensor.

11. The method according to any one of the preceding clauses, wherein the method further comprises the step of energizing the cleaning unit such that the electromagnetic radiation is generated.

12. The method according to any one of the preceding clauses, wherein the cleaning unit comprises a hydrogen radical generator comprising an outlet for emitting a flow of hydrogen radical containing gas, and, in step a), the sensor and/or the cleaning unit are moved for the sensor to receive the flow.

13. The method according to any one of the preceding clauses, wherein, in step a), the sensor and/or the cleaning unit are moved in accordance with a predetermined expected relative position of the sensor with respect to the cleaning unit.

14. The method according to any one of the preceding clauses, wherein the object to be cleaned is the sensor.

15. The method according to any one of the preceding clauses, wherein, in step b), the exposure time of the sensor is determined in accordance with an intensity of the electromagnetic radiation.

16. A method of cleaning an object to be cleaned with a cleaning unit, the method comprising the steps of:

• calibrating the cleaning position of the object to be cleaned with respect to the cleaning unit by performing the method according to any one of the preceding clauses;
• moving the object to be cleaned and/or the cleaning unit such that the object to be cleaned is in the cleaning position with respect to the cleaning unit;
• cleaning the object to be cleaned using the cleaning unit.

17. A computer program comprising program instructions configured to cause a processing system to perform the method according to any one the preceding clauses when the program is executed by the processing system.

18. A processing system comprising a processor and a storage device, the storage device comprising the computer program according to clause 17.

19. A metrology, inspection and/or sensor apparatus comprising the processing system according to clause 18.

20. The metrology, inspection and/or sensor apparatus according to clause 19, comprising a transmission image sensor, a wavefront sensor, a level sensor, an alignment sensor and/or a sensor for aligning a first object support to a second object support.

21. An exposure apparatus comprising the processing system according to clause 18.

22. An exposure apparatus comprising the metrology, inspection and/or sensor apparatus according to clause 19 or 20.

23. A workpiece support, such as an object table or a mask table, for an exposure apparatus comprising a cleaning unit configured to generate electromagnetic radiation, the workpiece support having mounted thereon an object to be cleaned and a sensor, wherein the workpiece support is configured to:

a) move the sensor for the sensor to receive the electromagnetic radiation;
b) measure the electromagnetic radiation using the sensor;
c) determine an alignment-improved position of the sensor with respect to the cleaning unit based on the measured electromagnetic radiation;
d) determine the cleaning position of the object to be cleaned in accordance with the alignment-improved position of the sensor.

24. An exposure apparatus, comprising:

- a workpiece support, such as the workpiece support according to clause 23, with mounted thereon an object to be cleaned and a sensor;
- a cleaning unit configured to clean the object to be cleaned, the cleaning unit being configured to generate electromagnetic radiation;

wherein the exposure apparatus is configured to:

a) move the image sensor and/or the cleaning unit for the sensor to receive the electromagnetic radiation;
b) measure the electromagnetic radiation using the sensor;
c) determine an alignment-improved position of the sensor with respect to the cleaning unit based on the measured electromagnetic radiation;
d) determine the cleaning position of the object to be cleaned in accordance with the alignment-improved position of the sensor.

25. The exposure apparatus according to clause 24, wherein the cleaning unit is configured to emit electromagnetic radiation in a direction transverse to the workpiece support.

26. The exposure apparatus according to any one of clauses 24-25, wherein:

the sensor is an image sensor comprising an array of sensor elements;
the cleaning unit comprising a source for generating a light beam;
the exposure apparatus is configured to:

in step b), measure the light beam using the array of sensor elements, resulting in a plurality of light beam measurements; and
in step c), determine the alignment-improved position of the image sensor with respect to the cleaning unit based on the plurality of light beam measurements.

27. The exposure apparatus according to clause 26, wherein the image sensor further comprises an aperture pattern through which the light beam passes before being received by the image sensor, and wherein each of the plurality of light beam measurements corresponds to a respective aperture of the aperture pattern.

28. The exposure apparatus according to any one of clauses 26-27, wherein the source is a filament or a plasma or laser source.

29. The exposure apparatus according to any one of clauses 26-28, wherein the cleaning unit comprises a plurality of sources each for generating a distinct light beam, the sources being arranged in a pattern, and wherein the exposure apparatus is configured to, in step a), move the image sensor and/or the cleaning unit for the image sensor to receive the light beams generated by the plurality of sources.

30. The exposure apparatus according to any one of clauses 24-29, wherein the cleaning unit comprises a hydrogen radical generator comprising an outlet for emitting a flow of hydrogen radical containing gas, and the exposure apparatus is configured to, in step a), move the sensor and/or the cleaning unit for the sensor to receive the flow.

31. The exposure apparatus according to any one of clauses 24-30, wherein the object to be cleaned is the sensor.

32. The exposure apparatus according to any one of clauses 24-31, wherein the exposure apparatus is further configured to:

- move the object to be cleaned and/or the cleaning unit such that the object to be cleaned is in the cleaning position with respect to the cleaning unit;
- clean the object to be cleaned using the cleaning unit.

**Claims**

1. A method of calibrating a cleaning position of an object to be cleaned with respect to a cleaning unit, the cleaning unit being configured to emit electromagnetic radiation measurable by a sensor, the method comprising the following steps:

a) moving the sensor and/or the cleaning unit for the sensor to receive the electromagnetic radiation;
b) measuring the electromagnetic radiation using the sensor;
c) determining an alignment-improved position of the sensor with respect to the cleaning unit based on the measured electromagnetic radiation;
d) determining the cleaning position of the object to be cleaned in accordance with the alignment-improved position of the sensor.

2. The method according to claim 1, wherein the object to be cleaned and the sensor are mounted on a workpiece support, such as an object table or a mask table, and wherein the cleaning unit is configured to emit electromagnetic radiation in a direction transverse to the workpiece support.

3. The method according to any one of the preceding claims, wherein:

the sensor is an image sensor comprising an array of sensor elements;
the cleaning unit comprising a source for generating a light beam;
in step b), the method measures the light beam using the array of sensor elements, resulting in a plurality of light beam measurements; and
in step c), the method determines the alignment-improved position of the image sensor with respect to the cleaning unit based on the plurality of light beam measurements.

4. The method according to claim 3, wherein the image sensor further comprises an aperture pattern through which the light beam passes before being received by the image sensor, and wherein each of the plurality of light beam measurements corresponds to a respective aperture of the aperture pattern.

5. The method according to any one of claims 3-4, wherein the source is a filament or a plasma or laser source.

6. The method according to any one of claims 3-5, wherein the cleaning unit comprises a plurality of sources each for generating a distinct light beam, the sources being arranged in a pattern, wherein, in step a), the image sensor and/or the cleaning unit are moved for the image sensor to receive the light beams generated by the plurality of sources.

7. The method according to any one of the preceding claims, wherein, in step d), the cleaning position of the object to be cleaned is additionally determined in accordance with a predetermined fixed relative position of the object to be cleaned with respect to the sensor.

8. The method according to any one of the preceding claims, wherein the method further comprises the step of energizing the cleaning unit such that the electromagnetic radiation is generated.

9. The method according to any one of the preceding claims, wherein the cleaning unit comprises a hydrogen radical generator comprising an outlet for emitting a flow of hydrogen radical containing gas, and, in step a), the sensor and/or the cleaning unit are moved for the sensor to receive the flow.

10. A computer program comprising program instructions configured to cause a processing system to perform the method according to any one the preceding claims when the program is executed by the processing system.

11. A processing system comprising a processor and a storage device, the storage device comprising the computer program according to claim 10.

12. A metrology, inspection and/or sensor apparatus comprising the processing system according to claim 11.

13. An exposure apparatus comprising the processing system according to claim 11.

14. A workpiece support, such as an object table or a mask table, for an exposure apparatus comprising a cleaning unit configured to generate electromagnetic radiation, the workpiece support having mounted thereon an object to be cleaned and a sensor, wherein the workpiece support is configured to:

a) move the sensor for the sensor to receive the electromagnetic radiation;
b) measure the electromagnetic radiation using the sensor;
c) determine an alignment-improved position of the sensor with respect to the cleaning unit based on the measured electromagnetic radiation;
d) determine the cleaning position of the object to be cleaned in accordance with the alignment-improved position of the sensor.

15. An exposure apparatus, comprising:

- a workpiece support, such as the workpiece support according to claim 14, with mounted thereon an object to be cleaned and a sensor;
- a cleaning unit configured to clean the object to be cleaned, the cleaning unit being configured to generate electromagnetic radiation;

wherein the exposure apparatus is configured to:

a) move the image sensor and/or the cleaning unit for the sensor to receive the electromagnetic radiation;
b) measure the electromagnetic radiation using the sensor;
c) determine an alignment-improved position of the sensor with respect to the cleaning unit based on the measured electromagnetic radiation;
d) determine the cleaning position of the object to be cleaned in accordance with the alignment-improved position of the sensor.

**FIG. 1**

**FIG. 2A**

**FIG. 2B**

start

S301

moving the sensor and/or the cleaning unit for the sensor to receive the electromagnetic radiation

S302

measuring the electromagnetic radiation using the sensor

S303

determining an alignment-improved position of the sensor with respect to the cleaning unit based on the measured electromagnetic radiation

S304

determining the cleaning position of the object to be cleaned in accordance with the alignment-improved position of the sensor

end

**FIG. 3**

**FIG. 4A**

**FIG. 4B**

CU

O

F

IS

WT

**FIG. 5A**

RS

CU

**FIG. 5B**

**FIG. 6A**

**FIG. 6B**